# FASCICULE DE BREVET EUROPEEN

(11) **EP 3 242 041 B1**
(45) Date de publication et mention de la délivrance du brevet: **02.01.2019**
(21) Numéro de dépôt: 17168612.4
(22) Date de dépôt: 28.04.2017
(51) Int. Cl.: B60W 30/18, F16H 61/421, F02D 29/04, F15B 11/05, F15B 11/02, H01L 41/09, F15B 13/043, F16K 31/00, F15B 15/02

(54) **SERVOVALVE A ACTIONNEUR PIEZO ELECTRIQUE REDONDANT ASYMETRIQUE**
SERVOVENTIL MIT ASYMMETRISCHEM REDUNDANTEM PIEZOELEKTRISCHEM STELLGLIED
SERVO VALVE WITH ASYMMETRIC REDUNDANT PIEZOELECTRIC ACTUATOR

(30) Priorité: 03.05.2016 FR 1653985
(43) Date de publication de la demande: 08.11.2017
(73) Titulaire: Zodiac Hydraulics, 28200 Châteaudun (FR)
(72) Inventeur: BERTRAND, Jean-Luc, 45000 Orléans (FR); MAILHAN, Catherine, 41100 VENDOME (FR)
(74) Mandataire: Prouvez, Julien

(56) Documents cités:
- EP-A1- 0 012 743
- EP-A1- 0 504 465
- WO-A1-01/59306
- DE-A1- 4 431 600

## Description

### DOMAINE DE L'INVENTION

L'invention est relative à un étage de pilotage de servovalve, pouvant servir de premier étage dans une servovalve à deux étages.

### ARRIERE-PLAN TECHNOLOGIQUE DE L'INVENTION

Une servovalve classique est constituée d'un étage de pilotage pilotant un organe mobile de distribution de puissance d'un étage de puissance. L'étage de puissance a pour fonction de délivrer une pression ou un débit proportionnel à une instruction transmise à l'étage de pilotage.

L'étage de pilotage comporte deux éléments hydrauliques, à savoir un émetteur hydraulique (buse ou éjecteur) et un récepteur hydraulique (palette, déflecteur ou récepteur fixe) dont la modification de leur position relative génère des différentiels de pression qui sont exploités pour déplacer finement un organe mobile de distribution de puissance de l'étage de puissance de la servovalve. Cet organe mobile de distribution de puissance coulisse dans une chemise cylindrique implantée dans le corps de la servovalve. Généralement, la position relative des éléments hydrauliques est pilotée par un moteur couple comprenant un jeu de bobines agissant sur une palette magnétique mobile solidaire d'un des éléments hydrauliques de l'étage de pilotage. Un courant de consigne appliqué par une unité de commande aux bobines du moteur couple provoque un déplacement de la palette et donc une modification de la position relative de l'élément hydraulique lié à celle-ci par rapport à l'élément hydraulique fixe, solidaire du corps. Le déplacement de l'organe mobile de distribution de puissance dans sa chemise met alors en communication un ensemble de canaux forés et de lumières dont l'agencement permet de délivrer une pression ou un débit, proportionnels au déplacement dudit organe mobile de distribution de puissance.

Une telle servovalve est couramment reliée à un actionneur hydraulique, comme par exemple un actionneur de volet d'aile d'aéronef, pour former un dispositif de commande de cet actionneur.

Pour les fonctions particulièrement critiques d'un aéronef telles que les commandes de vol ou les circuits de freinage, il est fréquent de disposer un second jeu de bobines dans le moteur couple en parallèle du premier de manière à ce que le second jeu de bobines prenne le relais en cas de défaillance (court-circuit ou circuit ouvert) du premier jeu de bobines. Ceci obéit au principe de sureté de fonctionnement par redondance parallèle des systèmes.

Une telle servovalve nécessite un circuit magnétique et des aimants permanents chargés, ce qui augmente la complexité du montage et la dispersion des performances. En effet, la performance d'une telle servovalve est sensible aux variations des propriétés magnétiques des matériaux utilisés dans le circuit magnétique. Enfin, il est nécessaire, lors de la construction d'une telle servovalve, de prévoir une étape de réglage de l'aimantation des aimants permanents.

Un étage de pilotage de servovalves de ce type est déjà connu du document EP 0012743.

### OBJET DE L'INVENTION

L'invention a pour objet de simplifier les opérations de fabrication d'une servovalve et d'en réduire la dispersion des performances.

### RESUME DE L'INVENTION

En vue de la réalisation de ce but, on propose un étage de pilotage pour servovalve, l'étage de pilotage comportant un élément hydraulique pour éjecter un jet de fluide et un élément hydraulique pour recevoir le jet de fluide, les éléments hydrauliques pouvant être déplacés l'un par rapport à l'autre de sorte à modifier leur position relative et à ainsi générer un différentiel de pression, l'un des deux éléments hydrauliques étant monté fixe sur un corps de la servovalve et l'autre des éléments hydrauliques étant solidaire d'un élément mobile de l'étage de pilotage déplaçable par rapport à un corps de la servovalve par des moyens d'actionnement. Selon l'invention, les moyens d'actionnement comprennent un premier et un deuxième actionneur piézoélectrique montés en série.

Avantageusement, l'allongement maximal du premier actionneur piézoélectrique est sensiblement égal à la moitié de l'allongement maximal du deuxième actionneur piézoélectrique. Cet agencement particulier permet au premier étage d'assurer un retour à une position de sécurité dans toutes les configurations de pannes.

L'invention comprend également un dispositif de commande d'un actionneur hydraulique comprenant une telle servovalve et une unité de commande dans lequel l'unité de commande adopte sélectivement une configuration de commande parmi une pluralité de configurations de commande, la pluralité de configurations de commande comprenant une première configuration de commande dite normale et une deuxième configuration de commande dite dégradée,
- dans la configuration normale, l'unité de commande alimente au moins le premier actionneur ;
- dans la configuration dégradée, l'unité de commande alimente au moins le deuxième actionneur.

D'autres caractéristiques et avantages de l'invention ressortiront à la lumière de la description qui suit de modes de réalisation particuliers non limitatifs de l'invention.

### BREVE DESCRIPTION DES FIGURES

Il sera fait référence aux figures annexées parmi lesquelles:
- la figure 1 est une représentation schématique d'une servovalve comprenant un premier étage selon l'invention;
- la figure 2 est une vue schématique des moyens d'actionnement selon l'invention ;
- la figure 3 est une vue schématique partielle du premier étage de la servovalve de la figure 1 dans une première position particulière d'une première configuration de commande;
- la figure 4 est une vue schématique partielle du premier étage de la servovalve de la figure 1 dans une deuxième position particulière d'une première configuration de commande;
- la figure 5 est une vue schématique partielle du premier étage de la servovalve de la figure 1 dans une deuxième position particulière d'une première configuration de commande;
- les figures 6 et 7 sont des vues schématiques partielles du premier étage de la servovalve de la figure 1 dans des positions particulières d'une deuxième configuration de commande;
- la figure 8 est une vue schématique partielle du premier étage de la servovalve de la figure 1 dans des positions particulières d'une troisième configuration de commande.

### DESCRIPTION DETAILLEE DE L'INVENTION

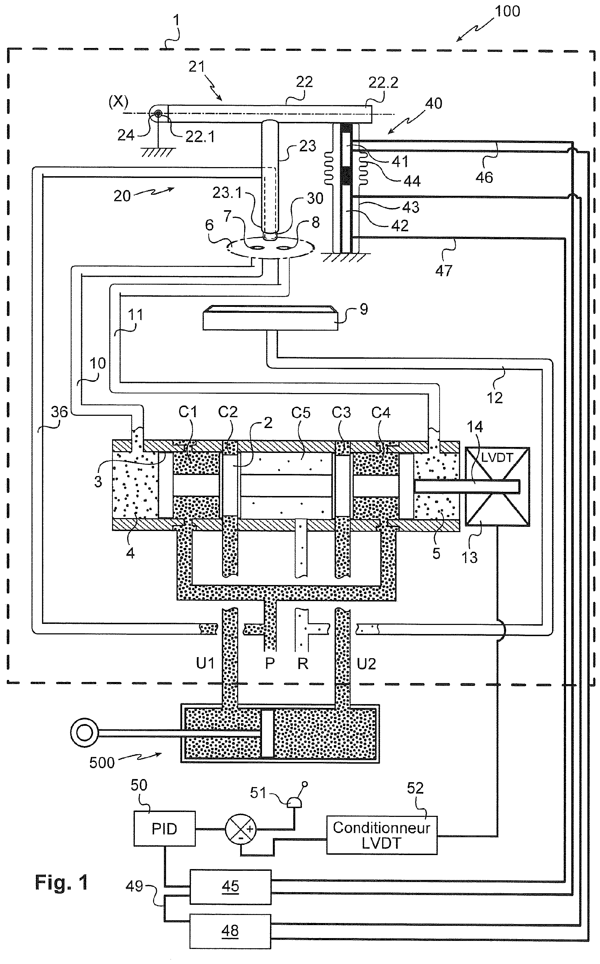

En référence à la figure 1, l'invention est ici illustrée en application à une servovalve de régulation de débit barométrique à deux étages dont un étage de pilotage. Bien entendu, l'invention n'est pas limitée à cette application, et pourra être utilisée pour d'autres types de servovalves. La servovalve généralement désignée 100 comporte un corps 1 dans lequel un organe de distribution de puissance 2 est monté pour coulisser à étanchéité dans un logement 3 cylindrique en formant l'étage de distribution. L'organe de distribution de puissance 2 est mobile entre deux positions extrêmes et est conformé pour délimiter dans le logement 3 des chambres étanches C1, C2, C3, C4 et C5 et pour ainsi mettre en communication respectivement, selon la position de l'organe de distribution de puissance 2 par rapport à une position centrée (ou position neutre) :
- soit un port d'alimentation P avec un premier port d'utilisation U1, et un port de retour R avec un deuxième port d'utilisation U2,
- soit le port d'alimentation P avec le deuxième port d'utilisation U2, et le port de retour R avec le premier port d'utilisation U1.

Le contrôle du coulissement de l'organe de distribution de puissance 2 dans le logement 3 est assuré au moyen de chambres de pilotage 4,5 qui sont alimentées en fluide sous pression par un organe de répartition de pression, en l'occurrence ici un récepteur 6 fixe. Le récepteur 6 comprend deux orifices 7 et 8 respectivement en communication fluidique, via des conduits 10 et 11, avec les chambres de pilotage 4 et 5. Un réceptacle 9 situé sensiblement à l'aplomb du récepteur 6 collecte le fluide hydraulique lorsque celui-ci n'est dirigé vers aucun des orifices 7 ou 8. Le réceptacle 9 est relié au retour R par un conduit 12. Un capteur 13 linéaire de type LVDT mesure la position de l'organe mobile de distribution de puissance 2 dans son logement 3. Le noyau 14 du capteur 13 est relié à l'organe mobile de distribution de puissance 2 par une tige traversant une des extrémités du logement cylindrique 3.

L'étage de pilotage 20 de la servovalve 1 comprend un élément mobile 21 qui comporte une première portion 22 de section rectangulaire et une seconde portion 23 tubulaire venant en saillie orthogonale du milieu de la portion 22.

Les première et deuxième portions 22 et 23 forment un ensemble mobile 21 ayant sensiblement une section en forme de T. Une première extrémité 22.1 de la première portion 21 est articulée par un axe 24 sur le corps 1 de la servovalve 100. L'autre extrémité 22.2 opposée à l'extrémité 21.1 repose sur des moyens d'actionnement 40 s'étendant selon une direction sensiblement perpendiculaire à un axe longitudinal (X) de la première portion 22. La deuxième portion tubulaire 23 est fluidiquement reliée au port d'alimentation P par un conduit 36 et comprend en son extrémité 23.1 un éjecteur 30 à fluide pour éjecter un jet de fluide vers les orifices 7 ou 8 selon la position relative de l'éjecteur 30 et des orifices 7 et 8.

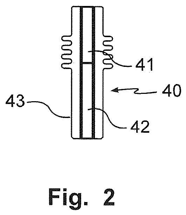

Les moyens d'actionnement 40 comprennent un premier actionneur 41 piézoélectrique et un deuxième actionneur 42 piézoélectrique montés en série, comme représenté en figure 2. Un capot 43 métallique s'étend autour des premier et deuxième actionneurs 41 et 42 et comprend un soufflet élastique 44 qui permet de soumettre le premier et le deuxième actionneur 41 et 42 à une même précharge. Au sens de la présente demande, deux actionneurs sont montés en série lorsqu'ils sont agencés de manière à ce que leurs allongements respectifs s'additionnent.

Le premier actionneur 41 et le deuxième actionneur 42 sont respectivement reliés à une unité de commande 45 par un premier câble 46 et un deuxième câble 47. L'unité de commande 45 est agencée pour alimenter les premier et deuxième actionneurs 41 et 42. Un module de surveillance 48, connu de l'homme du métier, surveille le fonctionnement des premier et deuxième actionneurs 41 et 42 et informe l'unité de commande 45 de l'état de fonctionnement des premier et deuxième actionneurs 41 et 42 via un câble 49. L'ensemble constitué par la servovalve 100 et l'unité de commande 45 constitue alors un dispositif de commande d'un actionneur hydraulique 500 de commande d'un volet d'aile d'un aéronef relié aux ports d'utilisation U1 et U2. L'unité de commande 45 est elle-même reliée à un régulateur 50 PID recevant un signal d'erreur provenant de la différence entre la consigne exercée sur une commande de pilotage 51 et une mesure de la position de l'organe de distribution de puissance 2 transmise par le capteur 13 dont le signal est préalablement traité par un conditionneur 52.

Selon la consigne appliquée sur la commande 51 et les informations fournies au régulateur 50, une instruction est envoyée à l'unité de commande 45. Celle-ci applique un couple de tensions aux bornes du premier et du deuxième actionneur 41 et 42. Les allongements A41 et A42 respectivement des actionneurs 41 et 42 sont proportionnels aux tensions qui leur sont appliquées. L'allongement A40 total des moyens d'actionnement 40, qui est égal à la somme des allongements A41 et A42 des actionneurs 41 et 42, provoque un déplacement de l'éjecteur 30 en regard des orifices 7 et 8 du récepteur 6. Le différentiel de pression créé provoque le déplacement de l'organe mobile de distribution de puissance 2 et donc une modification des pressions en sortie des ports d'utilisation U1 et U2. Le couple de pression U1 et U2 provoque un déplacement de l'actionneur hydraulique 500.

Dans le cas présent, les premier et deuxième actionneurs 41 et 42 ont respectivement un allongement maximal Amax41 et Amax42. Ici, l'allongement maximal Amax41=δ du premier actionneur 41 est sensiblement égal à la moitié de l'allongement maximal Amax42=2δ du deuxième actionneur 42.

A titre de rappel, deux types de pannes peuvent affecter un actionneur piézoélectrique. Soit il est en court-circuit, ceci étant généralement dû à un défaut interne. Soit il est en circuit ouvert, ce qui peut se produire en cas de défaillance de la connectique à laquelle il est relié. Lorsqu'un actionneur piézoélectrique est en court-circuit, il se décharge et reprend sa longueur initiale qui correspond à une tension nulle appliquée à ses bornes. Lorsqu'un actionneur piézoélectrique est en circuit ouvert, il conserve sa longueur et revient très lentement à sa longueur initiale en une durée généralement supérieure à une heure.

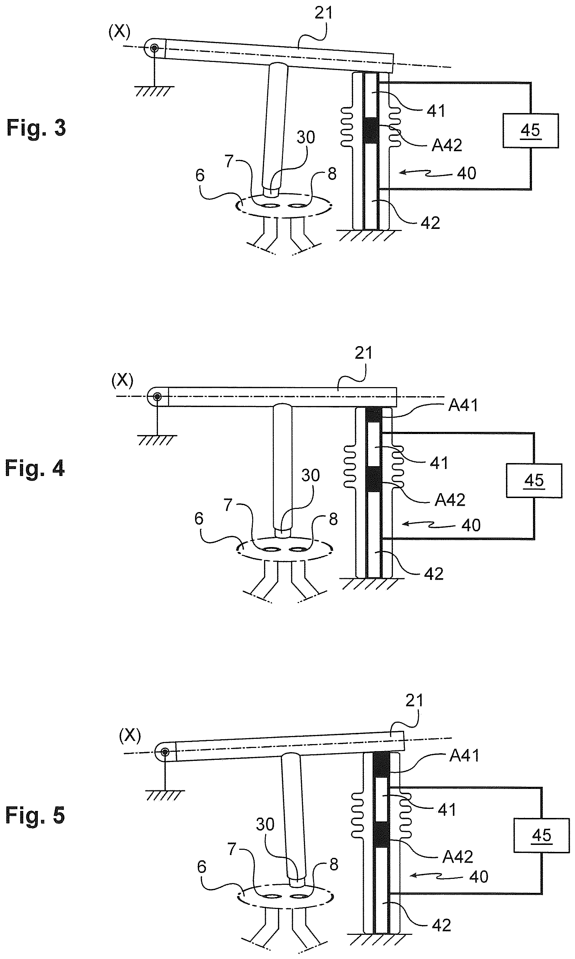

Les figures 3 à 8 représentent quelques configurations de commande particulières que peut adopter l'unité de commande 45 et l'état des premier et deuxième actionneurs 41 et 42 soumis à ces configurations de commande particulières. Sur ces figures, les allongements des premier et deuxième actionneurs sont représentés sous la forme de portions noircies.

Dans une première configuration de commande, dite normale, l'unité de commande 45 applique les tensions suivantes aux actionneurs :
- premier actionneur 41 alimenté à une tension variable qui est fonction de la consigne appliquée sur la commande 51, éventuellement corrigée par le régulateur 50 ;
- deuxième actionneur 42 alimenté à une tension constante correspondant à un allongement A42 du deuxième actionneur 42 égale à Amax42/2.

Dans la configuration de commande normale l'allongement A40 des moyens d'actionnement 40 est donc égal à A40= (Amax42/2)+A41=δ+A41 et l'extrémité des moyens d'actionnement 40 peut être positionnée dans une plage d'allongement des moyens d'actionnement 40 comprise dans la plage [δ ; 2δ]. Dans cette configuration, l'éjecteur 30 fait face à l'orifice 7 (figure 3) du récepteur 6 lorsque l'allongement A41 du premier actionneur 41 est nul (A40=δ). Le différentiel de pression ainsi créé entre les chambres de pilotage 4 et 5 entraine un déplacement de l'organe de distribution de puissance 2 dans son logement 3 vers la droite selon la représentation de la figure 1 (augmentation du volume de la chambre de pilotage 4).

Lorsque la tension appliquée aux bornes du premier actionneur 41 par l'unité de commande 45 est égale à la moitié de la tension maximale applicable, l'allongement du premier actionneur 41 est égal à la moitié de son allongement maximal et l'allongement A40 des moyens d'actionnement 40 est A40=(Amax42/2)+(Amax41/2)=1.5δ. L'éjecteur 30 est alors situé entre les deux orifices 7 et 8 du récepteur 6 et aucun différentiel de pression n'est créé entre les chambres de pilotage 4 et 5 (figure 4). L'organe de distribution de puissance 2 demeure donc immobile.

Lorsque la tension appliquée aux bornes du premier actionneur 41 par l'unité de commande 45 est égale à la tension maximale applicable, l'allongement A41 du premier actionneur 41 est égal à son allongement maximal Amax41= δ et l'allongement A40 de l'moyens d'actionnement 40 est A40= (Amax42/2)+Amax41=2δ. L'éjecteur 30 fait face à l'orifice 8 (figure 5) du récepteur 6. Le différentiel de pression ainsi créé entre les chambres de pilotage 4 et 5 entraine un déplacement de l'organe de distribution de puissance 2 dans son logement 3 vers la droite selon la représentation de la figure 1 (augmentation du volume de la chambre de pilotage 4). Dans cette configuration de commande normale, le premier actionneur 41 peut également adopter une pluralité de valeurs d'allongement A41 qui correspondent à autant de consignes possibles appliquées sur la commande 51.

Une deuxième configuration de commande, dite dégradée, est mise en oeuvre en cas de détection d'une défaillance du premier actionneur 41 par le module de surveillance 48. Dans cette configuration, l'unité de commande 45 alimente le deuxième actionneur 42 pour faire varier son allongement entre 0 et Aₘₐₓ42=2δ selon le type de défaillance du premier actionneur.

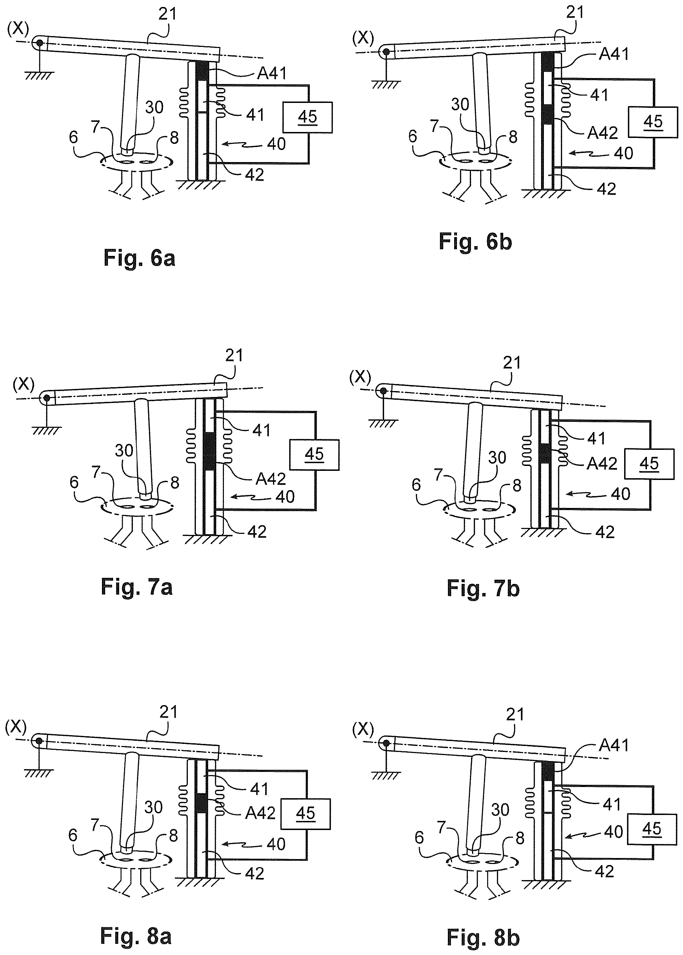

Si le premier actionneur est en circuit ouvert avec une valeur de son allongement comprise entre 0 et Aₘₐₓ41=δ (figures 6a-6b) ou en court-circuit avec un allongement égal à 0 (figures 7a-7b), l'unité de commande 45 peut appliquer une tension aux bornes du deuxième actionneur 42 permettant un allongement de celui-ci compris entre 0 et 2δ. Dans cette configuration dégradée, les moyens d'actionnement 40 sont toujours en mesure de couvrir une plage d'allongement égale à [δ ; 2δ] et donc de répondre aux consignes appliquées sur la commande 51.

En cas de détection d'une défaillance du deuxième actionneur 42, lorsque celui-ci est en circuit ouvert avec une valeur de son allongement égale à δ, le fonctionnement est identique à celui de la configuration normale, jusqu'à ce que l'allongement du deuxième actionneur 42 devienne inférieur à δ (figure 8a). Une troisième configuration, dite de sécurité, est alors mise en oeuvre lorsque le deuxième actionneur 42 présente un allongement inférieur à δ. Dans cette configuration, il n'est plus possible pour les moyens d'actionnement 40 de couvrir la plage d'allongement de [δ ; 2δ] et le premier actionneur 41 est alors alimenté pour atteindre un allongement maximal Aₘₐₓ41=δ de manière à ce que le récepteur 30 fasse au moins partiellement face à l'orifice 7 du récepteur 6 (figure 8b). Dans cette configuration conservative, la servovalve 100 adopte sa position de sécurité, à savoir un tiroir en butée d'un côté (ici le tiroir 2 est en butée contre la paroi droite du logement 3 selon la représentation de la figure 1) et donc un débit maximal entre U1 et U2. Ce cas est obtenu en fonctionnement normal pour une consigne minimale de la servovalve 1. La position de sécurité de la servovalve 1 est donc bien différente du zéro hydraulique de la servovalve 1 qui correspond à un débit nul entre U1 et U2.

On obtient ainsi un dispositif de commande d'un actionneur hydraulique 500 comprenant un premier et un deuxième actionneur piézoélectrique 41 et 42 redondants montés en série. L'utilisation d'actionneurs piézoélectriques améliore la fiabilité de manière intrinsèque car ce sont des actionneurs robustes et dont les taux de défaillance sont plus faibles que ceux de bobines. Pour une même application de déplacement d'un éjecteur à fluide face à un récepteur, les actionneurs piézoélectriques de l'invention possèdent une masse et un encombrement réduits par rapport aux solutions de l'art antérieur mettant en oeuvre des bobines.

L'invention n'est bien sûr pas limitée à ce qui vient d'être décrit, mais englobe toute variante entrant dans le cadre défini par les revendications.

En particulier,
- bien qu'ici le noyau du capteur LVDT soit relié à l'organe mobile de distribution de puissance par une tige traversant une des extrémités du logement cylindrique, l'invention s'applique également à d'autres moyens de détection de la position du tiroir, comme par exemple d'autres types de capteur de position passifs ou actifs : résistif, capacitif, ou optique par exemple;
- bien qu'ici l'élément mobile soit en forme de T dont une extrémité est articulée sur le corps de la servovalve, l'invention s'applique également à d'autres types d'éléments mobiles, comme par exemple un élément mobile en forme de L, un élément mobile s'étendant selon une unique direction longitudinale, ou un élément mobile de forme quelconque. L'élément mobile peut être articulé sur le corps, monté flottant ou encastré sur le corps, tant que la portion qui porte un des éléments hydrauliques est en mesure d'être déplacée par rapport à l'autre élément hydraulique sous l'action de l'actionneur ;
- bien qu'ici l'élément mobile comprenne une portion tubulaire qui relie fluidiquement le port d'alimentation à l'éjecteur de fluide, l'invention s'applique également à d'autres types d'alimentation en fluide comme par exemple une alimentation par flexible ou par un conduit externe rapporté sur la tige ;
- bien qu'ici les moyens d'actionnement comprenne un premier et un deuxième actionneur piézoélectrique, l'invention s'applique également à d'autres moyens d'actionnement pouvant contenir plus de deux actionneurs piézoélectriques ;
- bien qu'ici un capot métallique comprenant un soufflet élastique s'étende autour du premier et deuxième actionneur piézoélectrique, l'invention s'applique également à d'autres moyens de précharge des premier et deuxième actionneur piézoélectrique, comme par exemple un élément élastique monté en l'une des extrémités du premier ou du deuxième actionneurs piézoélectrique, le capot peut également être dans une autre matière comme un élastomère;
- bien qu'ici le rapport α entre l'allongement maximal du premier et du deuxième actionneur piézoélectrique soit sensiblement égal à 2 (l'allongement maximal du premier actionneur est sensiblement égal à la moitié de l'allongement maximal du deuxième actionneur), l'invention s'applique également à d'autres valeurs du rapport α entre les allongements maximaux du premier et du deuxième actionneur. Par exemple, si l'on privilégie la compacité de l'actionneur plutôt que sa capacité à conserver les pleines performances après une panne du premier actionneur piézoélectrique, le rapport α peut être compris entre un et deux et ainsi garantir un retour en position de sécurité. Si au contraire, on privilégie la fiabilité des moyens d'actionnement, le rapport α pourra être choisi supérieur à deux, ce qui permet de réduire la tension de commande appliquée au deuxième actionneur piézoélectrique et ainsi réduire son niveau de sollicitation et sa fatigue;
- bien qu'ici l'actionneur soit relié à un régulateur PID, l'invention s'applique également à d'autres types de régulateur comme par exemple des régulateurs proportionnel pur ou dérivé pur ou proportionnel dérivé ;
- bien qu'ici l'élément hydraulique fixe soit un récepteur de fluide et l'élément monté en l'extrémité de la tige soit un émetteur de fluide, l'invention s'applique également à un émetteur de fluide fixé sur un corps de la servovalve et à un récepteur de fluide, comme par exemple un déflecteur ou une palette, monté sur l'élément mobile ;
- bien qu'ici la pression d'alimentation soit délivrée aux chambres C4 et C1 et que la chambre C5 soit mise au retour, l'invention s'applique également à un étage de puissance dans lequel ces alimentations seraient inversées ;
- bien qu'ici la servovalve soit une servovalve à deux étages comprenant un étage de puissance comportant un organe de distribution de puissance dont la modification de la position est commandée par le différentiel de pression généré par le premier étage, l'invention s'applique également à une servovalve à simple étage dans laquelle le différentiel de pression est directement utilisé pour commander un actionneur ou une charge hydraulique ;
- bien qu'ici l'unité de commande alimente exclusivement le deuxième actionneur dans la configuration de commande dégradée, l'invention s'applique également à une configuration de commande dégradée dans laquelle l'unité de commande continue à alimenter le premier actionneur piézoélectrique ;
- bien qu'ici l'unité de commande alimente exclusivement le premier actionneur dans la configuration de commande de sécurité, l'invention s'applique également à une configuration de commande de sécurité dans laquelle l'unité de commande continue à alimenter le deuxième actionneur piézoélectrique;
- bien qu'ici l'unité de commande, dans la configuration de commande de sécurité, alimente le premier actionneur de manière à ce qu'il atteigne son allongement maximal, l'invention s'applique également à une configuration de commande de sécurité dans laquelle l'unité de commande alimente le premier actionneur piézoélectrique de manière à ce que l'éjecteur à fluide fasse en permanence face à l'orifice 7, quel que soit l'allongement du deuxième actionneur ;
- bien qu'ici le maintien de l'élément mobile dans une position telle que la servovalve soit dans sa position de sécurité soit assuré par l'alimentation des actionneurs piézoélectrique, l'invention s'applique également à un maintien en position de sécurité de l'élément mobile de manière à ce que la servovalve soit en position de sécurité à l'aide d'autres moyens comme par exemple un retour automatique (par son élasticité propre ou autre) de l'élément mobile en position de sécurité ou une butée maintenant l'élément mobile en position de sécurité ;
- bien qu'ici la servovalve et l'unité de commande 45 commandent un actionneur hydraulique de commande d'un volet d'aile d'un aéronef, l'invention s'applique également à la commande d'autres types d'actionneurs, comme par exemple des actionneurs hydrauliques de freinage, de direction d'inclinaison de pales.

## Revendications

1. Etage de pilotage (20) d'une servovalve (100), l'étage de pilotage (20) comportant un élément hydraulique (30) pour éjecter un jet de fluide et un élément hydraulique (6) pour recevoir le jet de fluide, les éléments hydrauliques (30, 6) pouvant être déplacés l'un par rapport à l'autre de sorte à modifier leur position relative et à ainsi générer un différentiel de pression, l'un des deux éléments hydrauliques (6) étant monté fixe sur un corps (1) de la servovalve (100) et l'autre des éléments hydrauliques (30) étant solidaire d'un élément mobile (21) de l'étage de pilotage (20) déplaçable par rapport à un corps de la servovalve (100) par des moyens d'actionnement (40), les moyens d'actionnement (40) comprenant un premier actionneur piézoélectrique (41) et un deuxième actionneur piézoélectrique (42) montés en série, **caractérisé en ce que**, l'allongement maximal (Amax41) du premier actionneur piézoélectrique (41) est sensiblement égal à la moitié de l'allongement maximal (Amax42) du deuxième actionneur piézoélectrique (42).

2. Etage de pilotage (20) selon la revendication 1, dans lequel l'élément hydraulique fixe est un récepteur de fluide (6) et l'élément hydraulique solidaire de l'élément mobile (21) est un éjecteur de fluide (30).

3. Etage de pilotage (20) selon l'une des revendications précédentes, dans lequel les moyens d'actionnement (40) comprennent un capot (43) s'étendant autour des premier et deuxième actionneurs piézoélectriques (41 ; 42), le capot (43) comprenant des moyens de précharge (44) des premier et deuxième actionneurs piézoélectriques (41 ; 42).

4. Etage de pilotage (20) selon la revendication 3, dans lequel les moyens de précharge (44) comprennent un soufflet élastique (44).

5. Dispositif de commande d'un actionneur hydraulique (500) comprenant une servovalve (100) comportant un étage de pilotage (20) selon la revendication 1 et une unité de commande (45), l'unité de commande (45) adoptant sélectivement une configuration de commande parmi une pluralité de configurations de commande, la pluralité de configurations de commande comprenant une première configuration de commande dite normale et une deuxième configuration de commande dite dégradée,
- dans la configuration normale, l'unité de commande (45) alimente au moins le premier actionneur piézoélectrique (41) ;
- dans la configuration dégradée, l'unité de commande (45) alimente au moins le deuxième actionneur piézoélectrique (42) .

6. Dispositif selon la revendication 5, dans lequel, dans la configuration normale, l'unité de commande (45) alimente le premier et le deuxième actionneur piézoélectrique (41 ; 42) .

7. Dispositif selon l'une des revendications 5 ou 6, dans lequel, dans la configuration dégradée, l'unité de commande (45) alimente seulement le deuxième actionneur piézoélectrique (42).

8. Dispositif selon l'une quelconque des revendications 5 à 7, dans lequel la pluralité de configurations de commande comprend une troisième configuration de commande dite de sécurité, dans laquelle un seul des actionneurs piézoélectrique (41 ; 42) est alimenté.

9. Dispositif selon la revendication 8, dans lequel, dans la configuration de sécurité, seul le premier actionneur piézoélectrique (41) est alimenté.

10. Dispositif selon l'une quelconque des revendications 5 à 9, dans lequel :
- dans la configuration normale, l'unité de commande (45) alimente le deuxième actionneur piézoélectrique (42) de manière à ce que celui-ci s'étende à la moitié de son allongement maximal (Amax42) quelle que soit la tension d'alimentation du premier actionneur piézoélectrique (41);
- dans la configuration dégradée, l'unité de commande (45) alimente le deuxième actionneur piézoélectrique (42) de manière à ce que celui-ci s'étende au-delà de la moitié de son allongement maximal (Amax42).

## Patentansprüche

1. Steuerstufe (20) eines Servoventils (100), wobei die Steuerstufe (20) ein hydraulisches Element (30) umfasst, um einen Fluidstrahl auszustoßen, sowie ein hydraulisches Element (6), um den Fluidstrahl aufzunehmen, wobei die hydraulischen Elemente (30, 6) relativ zueinander verschoben werden können, um ihre relative Position zu verändern und so ein Druckdifferential zu erzeugen, wobei eines der beiden hydraulischen Elemente (6) ortsfest an einem Gehäuse (1) des Servoventils (100) angebracht ist und das andere der hydraulischen Elemente (30) fest mit einem beweglichen Element (21) der Steuerstufe (20) verbunden ist, das in Bezug auf ein Gehäuse des Sensorventils (100) durch Betätigungsmittel (40) verschoben werden kann, wobei die Betätigungsmittel (40) einen ersten piezoelektrischen Aktor (41) und einen zweiten piezoelektrischen Aktor (42) umfassen, die in Reihe geschaltet sind, **dadurch gekennzeichnet, dass** die maximale Dehnung (Amax41) des ersten piezoelektrischen Aktors (41) im Wesentlichen gleich der Hälfte der maximalen Dehnung (Amax42) des zweiten piezoelektrischen Aktors (42) ist.

2. Steuerstufe (20) nach Anspruch 1, bei der das ortsfeste hydraulische Element ein Fluidaufnehmer (6) und das mit dem beweglichen Element verbundene hydraulische Element (21) ein Fluidausstoßer (30) ist.

3. Steuerstufe (20) nach einem der vorhergehenden Ansprüche, bei der die Betätigungsmittel (40) eine Abdeckung (43) umfassen, die sich um den ersten und den zweiten piezoelektrischen Aktor (41; 42) erstreckt, wobei die Abdeckung (43) Vorauflademittel (44) zum Voraufladen des ersten und des zweiten piezoelektrischen Aktors (41; 42) umfasst.

4. Steuerstufe (20) nach Anspruch 3, bei der die Vorauflademittel (44) einen elastischen Balg (44) umfassen.

5. Vorrichtung zur Steuerung eines hydraulischen Aktors (500), der ein Servoventil (100) umfasst, das eine Steuerstufe (20) nach Anspruch 1 und eine Steuereinheit (45) enthält, wobei die Steuereinheit (45) selektiv eine Steuerkonfiguration unter einer Vielzahl von Steuerkonfigurationen annimmt, wobei die Vielzahl von Steuerkonfigurationen eine erste sogenannte normale Steuerkonfiguration und eine zweite sogenannte degradierte Steuerkonfiguration umfasst,
- in der normalen Konfiguration die Steuereinheit (45) mindestens den ersten piezoelektrischen Aktor (41) versorgt;
- in der degradierten Konfiguration die Steuereinheit (45) mindestens den zweiten piezoelektrischen Aktor (42) versorgt.

6. Vorrichtung nach Anspruch 5, bei der in der normalen Konfiguration die Steuereinheit (45) den ersten und den zweiten piezoelektrischen Aktor (41; 42) versorgt.

7. Vorrichtung nach einem der Ansprüche 5 oder 6, bei der in der degradierten Konfiguration die Steuereinheit (45) nur den zweiten piezoelektrischen Aktor (42) versorgt.

8. Vorrichtung nach einem der Ansprüche 5 bis 7, bei der die Vielzahl von Steuerkonfigurationen eine dritte sogenannte Sicherheitssteuerkonfiguration umfasst, in der nur einer der piezoelektrischen Aktoren (41; 42) versorgt wird.

9. Vorrichtung nach Anspruch 8, bei der in der Sicherheitskonfiguration nur der erste piezoelektrische Aktor (41) versorgt wird.

10. Vorrichtung nach einem der Ansprüche 5 bis 9, bei der:
- in der normalen Konfiguration die Steuereinheit (45) den zweiten piezoelektrischen Aktor (42) derart versorgt, dass sich dieser zur Hälfte seiner maximalen Dehnung (Amax42) erstreckt, wie auch immer die Versorgungsspannung des ersten piezoelektrischen Aktors (41) ist;
- in der degradierten Konfiguration die Steuereinheit (45) den zweiten piezoelektrischen Aktor (42) derart versorgt, dass sich dieser über die Hälfte seiner maximalen Dehnung (Amax42) hinaus erstreckt.

## Claims

1. Driving stage (20) of a servo valve (100), the driving stage (20) including a hydraulic unit (30) for ejecting a jet of fluid and a hydraulic unit (6) for receiving the jet of fluid, the hydraulic units (30, 6) being able to be moved relative to each other so as to change their relative position and thereby to generate a pressure differential, one of the two hydraulic units (6) being fixedly mounted on a body (1) of the servo valve (100) and the other of the two hydraulic units (30) being integral with a mobile unit (21) of the driving stage (20), movable relative to a body of the servo valve (100) through actuating means (40), the actuating means (40) comprising a first piezoelectric actuator (41) and a second piezoelectric actuator (42) connected in series, **characterized in that** the maximum elongation (Amax41) of the first piezoelectric actuator (41) is substantially equal to half the maximum elongation (Amax42) of the second piezoelectric actuator (42).

2. Driving stage (20) according to Claim 1, in which the fixed hydraulic unit is a fluid receiver (6) and the hydraulic unit integral with the mobile unit (21) is a fluid ejector (30).

3. Driving stage (20) according to one of the preceding claims, in which the actuating means (40) comprise a cowling (43) extending around the first and second piezoelectric actuators (41 ; 42), the cowling (43) comprising means (44) for pre-charging the first and the second piezoelectric actuators (41 ; 42).

4. Driving stage (20) according to Claim 3, in which the pre-charging means (44) comprise an elastic bellows (44).

5. Device for controlling a hydraulic actuator (500) comprising a servo valve (100) including a driving stage (20) according to Claim 1 and a control unit (45), the control unit (45) selectively adopting one control configuration among a plurality of control configurations, the plurality of control configurations comprising a first control configuration called normal and a second control configuration called degraded,
- in the normal configuration, the control unit (45) powers at least the first piezoelectric actuator (41);
- in the degraded configuration, the control unit (45) powers at least the second piezoelectric actuator (42).

6. Device according to Claim 5, in which, in the normal configuration, the control unit (45) powers the first and the second piezoelectric actuator (41 ; 42).

7. Device according to one of Claims 5 or 6, in which, in the degraded configuration, the control unit (45) only powers the second piezoelectric actuator (42).

8. Device according to any one of Claims 5 to 7, in which the plurality of control configurations comprises a third control configuration called safety, in which only one of the piezoelectric actuators (41 ; 42) is powered.

9. Device according to Claim 8, in which, in the safety configuration, only the first piezoelectric actuator (41) is powered.

10. Device according to any one of Claims 5 to 9, in which:
- in the normal configuration, the control unit (45) powers the second piezoelectric actuator (42) so that the latter extends to half its maximum elongation (Amax42) whatever the power supply voltage of the first piezoelectric actuator (41) ;
- in the degraded configuration, the control unit (45) powers the second piezoelectric actuator (42) so that the latter extends beyond half its maximum elongation (Amax42).
